(19) **Europäisches Patentamt / European Patent Office / Office européen des brevets**

(11) **EP 3 399 543 B1**

(12) **EUROPEAN PATENT SPECIFICATION**

(45) Date of publication and mention
of the grant of the patent:
**22.12.2021 Bulletin 2021/51**

(51) Int Cl.:
**B23K 26/00** (2014.01)          **B23K 26/03** (2006.01)
**B23K 103/00** (2006.01)          **H01L 21/268** (2006.01)
**H01L 21/02** (2006.01)

(21) Application number: **16881213.9**

(22) Date of filing: **28.12.2016**

(86) International application number:
**PCT/CN2016/112662**

(87) International publication number:
**WO 2017/114424 (06.07.2017 Gazette 2017/27)**

(54) **LASER ANNEALING DEVICE AND ANNEALING METHOD THEREFOR**

LASERGLÜHVORRICHTUNG UND GLÜHVERFAHREN DAFÜR

DISPOSITIF DE RECUIT AU LASER ET PROCÉDÉ DE RECUIT POUR CELUI-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.12.2015 CN 201511021931**

(43) Date of publication of application:
**07.11.2018 Bulletin 2018/45**

(73) Proprietor: **Shanghai Micro Electronics
Equipment (Group) Co., Ltd.
Zhangjiang High-Tech Park
Shanghai 201203 (CN)**

(72) Inventors:
• **CUI, Guodong
Shanghai 201203 (CN)**
• **LAN, Yanping
Shanghai 201203 (CN)**
• **MA, Mingying
Shanghai 201203 (CN)**
• **SONG, Chunfeng
Shanghai 201203 (CN)**

• **SUN, Gang
Shanghai 201203 (CN)**

(74) Representative: **Lavoix
Bayerstraße 83
80335 München (DE)**

(56) References cited:
WO-A1-2006/113100          WO-A1-2012/173008
CN-A- 101 160 646          CN-A- 103 578 943
CN-A- 104 078 339          US-A1- 2004 198 028
US-A1- 2013 196 455          US-A1- 2014 097 171
US-A1- 2015 179 473          US-B1- 6 693 257

• JEFFREY MILEHAM ET AL: "Impact of pattern
and LSA stitching effects and processing
parameters on reflectance and stress distribution
for thermal annealing technologies", ADVANCED
THERMAL PROCESSING OF
SEMICONDUCTORS, 2009. RTP '09. 17TH
INTERNATIONAL CONFERENCE ON, IEEE,
PISCATAWAY, NJ, USA, 29 September 2009
(2009-09-29), pages 1-6, XP031595886, ISBN:
978-1-4244-3814-3

## Description

## Technical Field

The present invention relates to the field of laser annealing and, in particular, to a laser annealing device and associated annealing methods.

## Background

US 2013/196455 A1 relates to systems and methods for performing laser annealing in a manner that reduces or minimizes wafer surface temperature variations during the laser annealing process. The systems and methods include annealing the wafer surface with first and second laser beams that represent preheat and anneal laser beams having respective first and second intensities.

US 2014/097171 A1 relates to systems and methods for performing ultrafast laser annealing in a manner that reduces pattern density effects in integrated circuit manufacturing are disclosed. The method includes scanning at least one first laser beam over the patterned surface of a substrate.

In the fabrication of semiconductor devices, during an ion implantation process on a predetermined portion of a backside of a silicon substrate, the portion implanted with phosphorus (P) ions is often located closer to the surface than the portion implanted with boron (B) ions and the B ions usually have a higher concentration compared to the P ions which are located farther from the surface. This ion implantation process, however, tend to disrupt the crystallinity of the silicon substrate near the surface and lead to a disorderly distribution of ions there. In order to overcome these problems, laser annealing is usually performed on a semiconductor film formed on an insulating substrate such as a glass substrate, which can cause crystallization or enhance crystallinity and turn an amorphous material into a polycrystalline or monocrystalline one. When treated with such a laser annealing process, implanted dopant ions are dispersed among crystalline atoms in an orderly manner, which results in effective improvements in electrical properties of the treated material.

After a wafer undergoes a photolithography process, such as a TSV (Through Silicon Via) process, different nanoscale geometries exhibiting different properties are present at different locations on the surface of the wafer. Due to these geometries, absorption of the incident laser energy varies across the wafer surface. As a result, subsequent to the laser annealing process, a temperature distribution across the wafer surface is not homogeneous, i.e., rendering a so-called pattern effect.

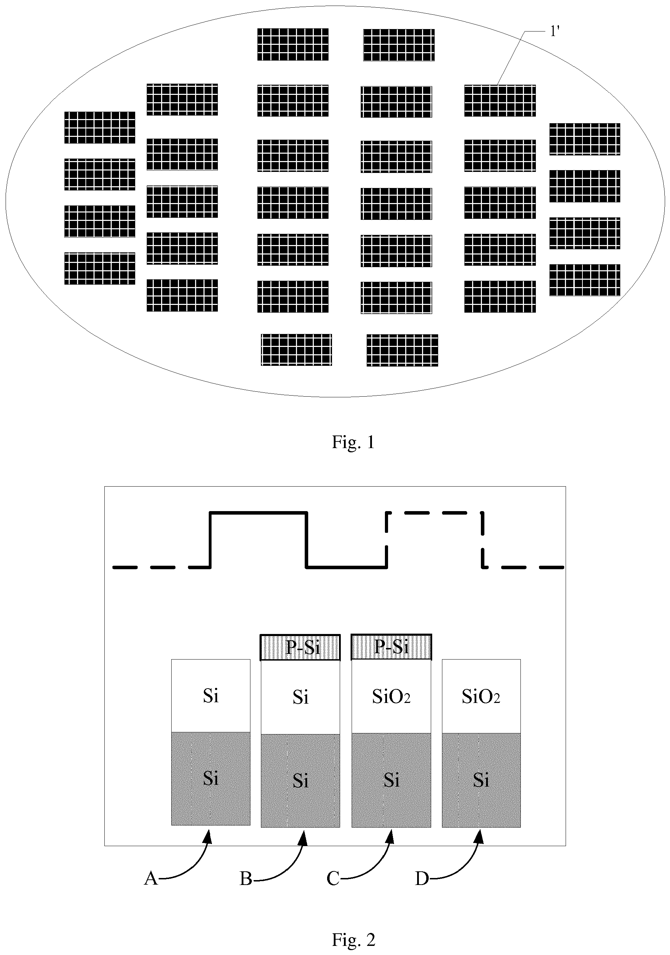

Fig. 1 schematically shows the surface of a wafer resulting from a photolithography process. As illustrated, there are a number of dies 1', represented by black blocks in the figure, on the wafer surface. As shown in Fig. 2, with the dies 1', periodic nanoscale structures each composed of surface portions of different materials are present on the wafer surface. As a result, the reflectance $R(x, y)$ of the wafer surface for the incident light varies with the position on the surface.

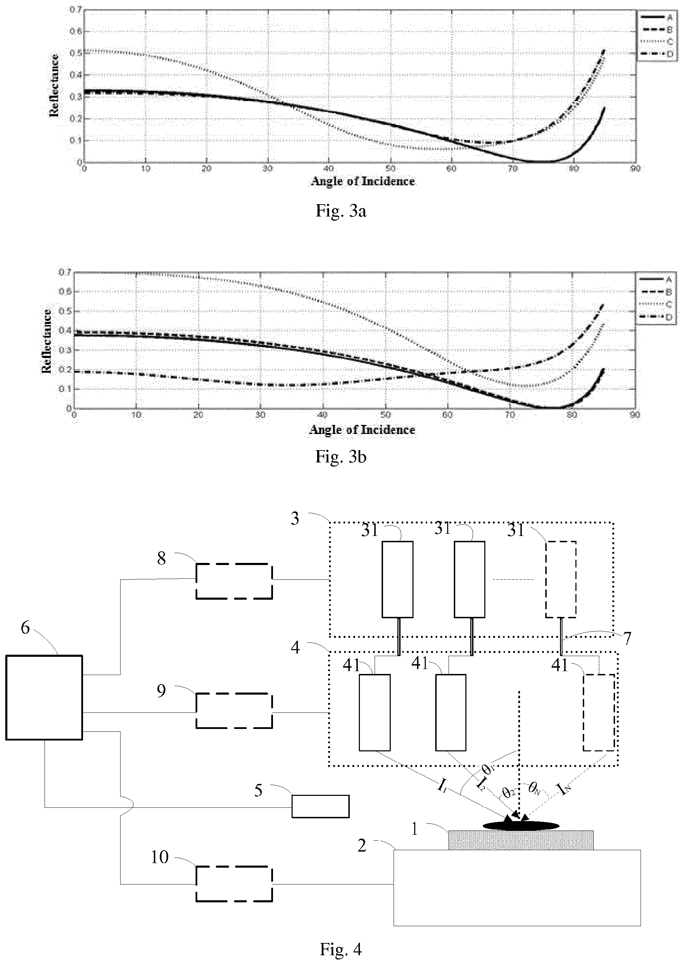

Moreover, pursuant to the theory of electromagnetic waves, for the surface of a certain material, the reflectance $R(\lambda, \theta)$ of the surface of the material is a function of the wavelength $\lambda$ of the incident light and its angle of incidence $\theta$. For laser light of a certain wavelength, when incident at different angles of incidence, the reflectance $R_\lambda(\theta)$ of the wafer surface varies with the angle of incidence of the light. Figs. 3a and 3b show reflectance profiles at the surface portions A, B, C and D of different materials shown in Fig. 2 as functions of angles of incidence at which 800- and 500-nm laser beams are incident on the surface portions. As can be seen from the figures, for incident light of the same wavelength, the reflectance $R_\lambda(\theta)$ varies with the angle of incidence; meanwhile, at the same angle of incidence, the reflectance $R_\lambda(\theta)$ varies with the wavelength of the incident light.

In summary, for a wafer resulting from a photolithography process, the reference $R(\lambda, \theta, x, y)$ of its surface for incident laser light is related to the surface position at which the light is incident, its wavelength and angle of incidence.

Conventional laser annealing techniques all use a laser as an energy source to irradiate the surface of a wafer to be treated until a target annealing temperature T0 is reached at the wafer surface. However, as the lasers employed in these conventional laser annealing techniques are all those emitting laser light at single wavelengths, the occurrence of a pattern effect at the wafer surface is inevitable, which may pose a significant adverse impact on performance consistency of the devices being fabricated, thus ruining the performance and reliability of photolithography.

## Summary of the Invention

In order to overcome the above problems, the present invention provides a laser annealing device and associated annealing methods.

The laser annealing device is provided according to claim 1.

Additionally, a laser light source control system may be connected between the central control system and the laser light source system, the laser light source control system configured to receive, from the central control system, a control command indicative of a control action on the power of the laser beam output from each of the lasers of the laser light source system and to feed a result of the control action back to the central control system.

Additionally, a laser adjustment control system may be connected between the central control system and the laser adjusting system, the laser adjustment control system configured to receive, from the central control system, a control command indicative of a control action on each of the laser adjustors in the laser adjusting system and to feed a result of the control action back to the central control system.

Additionally, a wafer table control system may be disposed between the central control system and the wafer table, the wafer table control system configured to receive, from the central control system, a control command indicative of a control action on movement of the wafer table and to feed a result of the control action back to the central control system.

Additionally, the temperature monitoring system may be a pyrometer or a reflectance detector.

Additionally, the lasers may be connected to the laser adjustors by optical fibers.

Additionally, the spot detection system may include a power meter, a CCD detector and an image collector.

Additionally, the light homogenization system may be implemented as a micro-lens array or an optical integrator rod.

Additionally, a beam expansion and collimation system may be disposed between the energy attenuation system and the light homogenization system.

Additionally, the rotation and translation member may include a galvanometer lens and a piezoelectric ceramic actuator.

Additionally, an F-$\theta$ lens may be disposed between the rotation and translation member and the wafer.

Additionally, the laser beams output from the at least two lasers may include at least two different wavelengths.

The present invention also provides a method for annealing using the laser annealing device as defined above, including the steps of:

S1) placing a wafer on a wafer table and adjusting the wafer to be horizontally oriented;
S2) determining, by the laser adjustors of the laser adjusting system, a location of the wafer at which a light spot is formed and determining an optimum set of process parameters based on reflectance at the location;
S3) adjusting the laser light source system and the laser adjusting system, exposing the location of the wafer at which the light spot is formed based on the optimum set of process parameters, measuring a temperature at the location by the temperature monitoring system and transmitting the temperature measurement to the central control system;
S4) determining whether the temperature is within a predefined temperature range by the central control system based on the received temperature measurement, if not, recording an exposure temperature at the location and, when a subsequent location of the wafer having a same reflectance is to be exposed, adjusting parameters of the laser light source system and of the laser adjusting system so that the wafer is exposed at an exposure temperature within the predefined temperature range, and if yes, causing the wafer table to move the wafer so that the light spot is located at a next location to be exposed; and
S5) determining whether the next location is a final location, if not, repeating steps S2) to S4) and otherwise, ending the method.

Additionally, in step S2), determining an optimum set of process parameters includes the steps of:

S21) selecting wavelengths for the respective lasers;
S22) for one of locations of the wafer, determining a plurality of sets of parameters each consisting of angles of incidence and powers of laser beams from the respective lasers;
S23) for a selected set of parameters, measuring reflectance and absorbance of the laser beams at the one of locations of the wafer and determining an exposure temperature for the selected set of parameters using a temperature model; and
S24) determining whether the exposure temperature is within a predefined temperature range, if not, performing step S23) for a next set of parameters, if yes, determining the selected set of parameters as the optimum set of process parameters and causing the wafer table to move the wafer to a next location and looping back to step S23), and repeating this method until all the locations of the wafer have been so treated.

The present invention also provides another method for annealing using the laser annealing device as defined above, including the steps of:

S1) placing a wafer on a wafer table and obtaining process parameters for the wafer;
S2) selecting at least two lasers based on the process parameters, producing laser beams by the selected lasers and adjusting annealing angles and powers for the laser beams; and
S3) annealing a surface of the wafer with a light spot jointly formed by the laser beams.

Additionally, in step S1), the process parameters may be selected based on a type of the wafer from an annealing parameter model established in advance from measured surface dimensions of different types of wafers.

Additionally, in step S1), the process parameters may be obtained by measuring in real time surface dimensions of the wafer.

Additionally, the process parameters may include surface dimensions of the wafer and reflectance indices of materials thereof.

Additionally, in step S2), based on the reflectance indices of the materials, at least two of the lasers that produce laser beams at different wavelengths may be selected and power of the laser beams may be adjusted.

Additionally, in step S2), based on the surface dimensions, different annealing angles may be enabled by adjusting angles of incidence of the laser beams using corresponding ones of the laser adjustors.

Additionally, in step S3), the light spot may have an energy distribution that is compatible with the dimensions of the wafer and the reflectance indices of the materials thereof.

In the laser annealing device and methods of the present invention, the wafer is jointly annealed by the laser beams from the multiple independent lasers, which have different wavelengths and cooperate in a mutually complementary manner, with the selected optimum set of process parameters. As a result, an optimum annealing temperature can be achieved and surface pattern effects can be effectively reduced. Additionally, with feedbacks from the temperature monitoring system and adjustments effected by the central control system, the annealing is performed in a more uniform and controllable manner with a reduced thermal budget and less thermal diffusion, which imparts enhanced process adaptability to the annealing device.

**Brief Description of The Drawings**

Fig. 1 schematically shows the surface of a wafer resulting from a conventional photolithography process.

Fig. 2 schematically shows in internal structure of the conventional wafer.

Figs. 3a and 3b show reflectance profiles at surface portions A, B, C and D of different materials shown in Fig. 2 as functions of angles of incidence at which 800- and 500-nm laser beams are incident on the surface portions.

Fig. 4 is a structural schematic of a laser annealing device according to the present invention.

Fig. 5 is a structural schematic of a laser adjustor according to the present invention.

Fig. 6 schematically illustrates a light spot formed on the surface of a wafer by laser beams emanated from three different lasers.

Fig. 7 shows the variation of a temperature deviation with the number of sets of process parameters in annealing processes using laser beams with wavelengths of 500 nm and 800 nm.

In Fig. 1, 1' denotes a die.

In Figs. 4 to 8: 1-wafer; 2-wafer table; 3-laser light source system; 31-laser; 4-laser adjusting system; 41-laser adjustor; 411-spot detection system; 412-energy attenuation system; 413-light homogenization system; 414-rotation and translation member; 415-beam expansion and collimation system; 416-F-0 lens; 5-temperature monitoring system; 6-central control system; 7-optical fibers; 8-laser light source control system; 9-laser adjustment control system; 10-wafer table control system.

**Detailed Description of Preferred Embodiments**

The present invention will be described in greater detail with reference to the accompanying drawings.

As shown in Fig. 4, the present invention provides a laser annealing device for laser annealing of a wafer 1 placed on a wafer table 2.

The laser annealing device includes a laser light source system 3 having at least two lasers 31 for outputting annealing laser beams onto the surface of the wafer 1. The laser beams may be output from the lasers 31 at independently tunable power levels and at different wavelengths.

The laser annealing device also includes a laser adjusting system 4 that is connected to the laser light source system 3 and located above the wafer 1. The laser adjusting system includes at least two laser adjustors 41 in one-to-one correspondence with the respective lasers 31. That is, the number of the laser adjustors 41 is equal to the number of the lasers 31. Each of the laser adjustors 41 is configured to monitor a corresponding one of the lasers 31 for the power of a laser beam emanated from the laser and the position of a light spot formed by the laser beams on the surface of the wafer 1 and to adjust the shape of the light spot and an angle of incidence of the laser beam. Preferably, the laser adjusting system 4 may be connected to the laser light source system 3 by optical fibers 7 for transmitting the laser beams.

The laser annealing device also includes a temperature monitoring system 5 that is disposed above the wafer 1 and configured to measure in real time a temperature at a location of the wafer surface at which the light spot is formed. Preferably, the temperature monitoring system 5 may be implemented as a pyrometer or a reflectance detector for measuring in real time the temperature at the location of the wafer surface at which the light spot is formed, and the obtained real-time temperature data may be fed back to a central control system 6 as a basis for feedback control. The temperature monitoring system 5 is schematically illustrated in Fig. 4 only for the purpose of explaining its connection with the central control system 6 and other components rather than limiting its actual position in the device. Therefore, it should be construed that the temperature monitoring system 5 is limited to the shown position in Fig. 4.

The laser annealing device also includes the central control system 6 that is connected to each of the laser light source system 3, the laser adjusting system 4, the temperature monitoring system 5 and the wafer table 2 and configured to receive data from the laser light source system 3, the laser adjusting system 4, the temperature monitoring system 5 and the wafer table 2 and control the laser light source system 3, the laser adjusting system 4 and the wafer table 2. Specifically, temperature data from the temperature monitoring system 5 may be processed by the central control system 6 and fed back in real time to the laser light source system 3 and the laser adjusting system 4 and reflected on the power and angle of incidence of the laser beam serving as two degrees of freedom of control, so that throughout the annealing process performed by the device, the temperature at the location of the wafer surface at which the light spot is formed is maintained within a predefined temperature range $T_0 \pm \Delta T$, where $T_0$ represents a target annealing temperature for the location of the wafer surface at which the light spot is formed and $\Delta T$ denotes an acceptable temperature deviation.

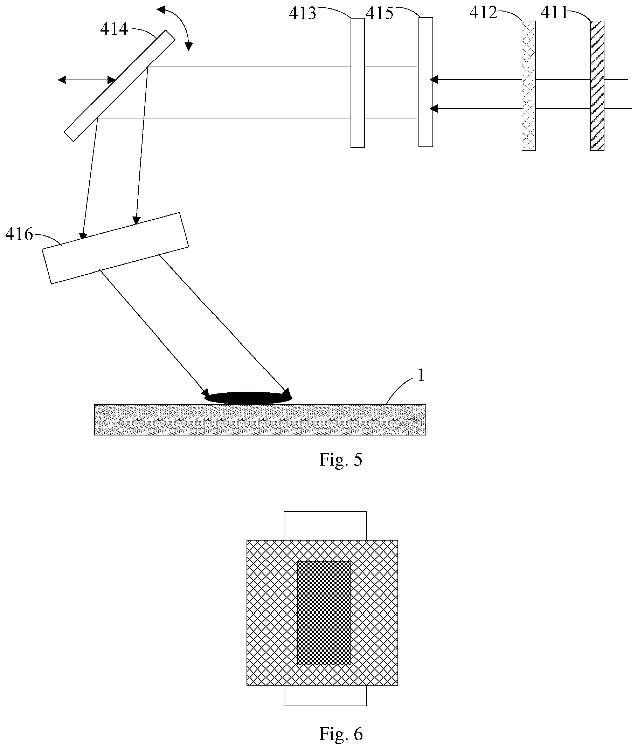

As shown in Fig. 5, each of the laser adjustors 41 may include, disposed sequentially along the optical path, a spot detection system 411, an energy attenuation system 412, a light homogenization system 413 and a rotation and translation member 414. The spot detection system 411 is connected to both a corresponding one of the lasers 31 and the central control system 6 and includes a power meter, a CCD detector and an image collector. The spot detection system is adapted to monitor in real time the power of a laser beam from the laser and the position of a light spot formed by the laser beam and to pass these data to the central control system 6. The energy attenuation system 412 may be composed of a polarizing beam-splitting prism and an attenuator or wave plate and is configured to adjust the energy that the laser beam applies to the wafer surface through scaling the portion of the laser beam that transmits through it or changing a polarization direction of the beam. The light homogenization system 413 may be implemented as a micro-lens array or an optical integrator rod for creating a specific light intensity distribution of the light spot formed by the laser beam on the wafer surface. The rotation and translation member 414 may include a galvanometer lens and a piezoelectric ceramic actuator. The rotation and translation member 414 may be disposed above the wafer 1 and may rotate or translate to change an angle at which the laser beam is incident on the wafer surface or adjust the position of the light spot with respect to the wafer surface.

With continued reference to Fig. 5, a beam expansion and collimation system 415 may be disposed between the energy attenuation system 412 and the light homogenization system 413. It may be implemented as a single lens or a telescope system for collimating the laser beams and adjusting the shape of the light spot formed on the wafer surface. Preferably, an F-θ lens 416 may be disposed between the rotation and translation member 414 and the wafer 1 for allowing the laser beams to form the light spot with a certain energy distribution on the wafer surface. Fig. 6 schematically illustrates a light spot formed on the wafer surface by laser beams emanated from three different lasers 31. In general, during the laser annealing process, the shape of the light spot assumes a linear distribution, i.e., a shape narrow in a scanning direction and wider in a non-scanning direction.

The light spot may result from complete or partial overlapping of multiple light spots formed by laser beams from the laser adjusting system. In general cases, the light spot has desired intensity and energy distributions in the scanning direction and uniform intensity and energy distributions in the non-scanning direction.

With continued reference to Fig. 4, between the central control system 6 and the laser light source system 3 may be connected a laser light source control system 8 configured to receive from the central control system 6 a control command indicative of a control action for imparting desired power to the laser beams output from the lasers 31 of the laser light source system 3 and feeding a result of the control action back to the central control system 6. In addition, each of the lasers 31 of the laser light source system 3 may transmit information about the wavelength and power of a laser beam that it is outputting to the central control system 6 via the laser light source control system 8.

With continued reference to Fig. 4, between the central control system 6 and the laser adjusting system 4 may be connected a laser adjustment control system 9 that is configured to receive from the central control system 6 a control command indicative of a control action for allowing the laser beams exiting the laser adjustors 41 of the laser adjusting system 4 to be incident at desired angles and have desired shapes and is adapted to feed a result of the control action back to the central control system 6.

Preferably, between the central control system 6 and the wafer table 2 may be disposed a wafer table control system 10 configured to receive from the central control system 6 a control command indicative of a control action on the movement of the wafer table 2 and to feed a result of the control action back to the central control system 6. Specifically, the wafer table 2 may be implemented as a motion stage that is able to move freely at least horizontally and drive the wafer 1 to move relative to the light spot so that every location of the wafer surface can be annealed by the light spot. Of course, it is necessary for the wafer 1 to be located within a depth of focus of the laser light source system 3.

The present invention also provides a method for annealing with the laser annealing device as defined above, which includes the following steps:

In step S1, the wafer 1 is placed on the wafer table 2 and the horizontal orientation of the wafer 1 is adjusted. In other words, the wafer 1 is adjusted to be horizontally oriented.

In step S2, a location Spot(x,y) of the wafer 1 at which a light spot is formed is determined based on positions of the laser adjustors 41 of the laser adjusting system 4, and an optimum set of process parameters $\{I_{\lambda_1}(\theta_1), I_{\lambda_2}(\theta_2), \cdots, I_{\lambda_N}(\theta_N)\}$ is determined based on reflectance R(x,y) of the wafer at the location Spot(x, y), where $I_{\lambda_N}(\theta_N)$ denotes the intensity of the laser beam from the N-th laser 31 that has a wavelength

$\lambda_N$ and is incident on the wafer surface at an angle $\theta_N$. Specifically, the location Spot(x,y) of the wafer at which the light spot is formed may be determined based on positions of the rotation and translation members 414 of the laser adjustors 41 relative to the wafer 1. The determination of the optimum set of process parameters may include the steps of:

S21) selecting wavelengths $\lambda_i$, $i$=1,2 ...$N$ for the individual lasers 31;

S22) for any location (x,y) of the wafer 1, adjusting angles of incidence and power outputs of the individual lasers 31 and determining m sets of parameters each consisting of the angles of incidence and the power outputs of the individual lasers 31, wherein the power of each laser 31 is maximum at its rated power, and the angle of incidence $\theta_i^m$ ranges from 0 to 90 degrees;

S23) for a selected one of the sets of parameters, measuring reflectance $R_{(x,y,\lambda_i,\theta_i)}^m$ and absorbance

$$I_{(x,y)}^m(\lambda_i,\theta_i) = (1 - R_{(x,y,\lambda_i,\theta_i)}^m)I_i^m \quad i = 1,2,\cdots N$$

of the laser beams from the lasers 31 at the location (x,y) of the wafer 1 and determining an exposure temperature $T_m$ for the selected set of parameters using a temperature model; and

S24) determining whether the exposure temperature $T_m$ is within the predefined temperature range $T_0 \pm \Delta T$, if the determination is negative, performing step S23) for the next set of parameters; if the determination is positive, determining the specific set of parameters as the optimum set of process parameters $\{I_{\lambda_1}(\theta_1), I_{\lambda_2}(\theta_2), \cdots, I_{\lambda_N}(\theta_N)\}$, and causing the wafer table 2 to move the wafer 1 to the next location and looping back to step S23), and repeating this process until all the locations of the wafer 1 have been so treated.

In step S3, the laser light source system 3 and the laser adjusting system 4 are adjusted by the laser light source control system 8 and the laser adjustment control system 9, respectively. The location of the wafer at which the light spot is formed is exposed based on the optimum set of process parameters, and a temperature at the location is measured by the temperature monitoring system 5, followed by passage of the temperature measurement on to the central control system 6.

In step S4, the central control system 6 determines whether the temperature is within the predefined temperature range $T_0 \pm \Delta T$ based on the received temperature measurement. If the determination is negative, the exposure temperature T(x,y) is recorded and, when a subsequent location of the wafer with the same reflectance is to be exposed, the central control system 6 adjusts, based on the recorded exposure temperature T(x,y), parameters of the laser light source system 3 and the laser adjusting system 4, including the power and angles of incidence of the laser beams, via the laser light source control system 8 and the laser adjustment control system 9, respectively, so that the location is exposed at an exposure temperature within the predefined temperature range. If the determination is positive, the wafer table control system 10 causes, under the control of the central control system 6, the wafer table 2 to move the wafer 1 so that the light spot is located at the next location to be exposed.

In step S5, it is determined whether the location is a final location. If not, steps S2-S4 are repeated. Otherwise, the process is ended.

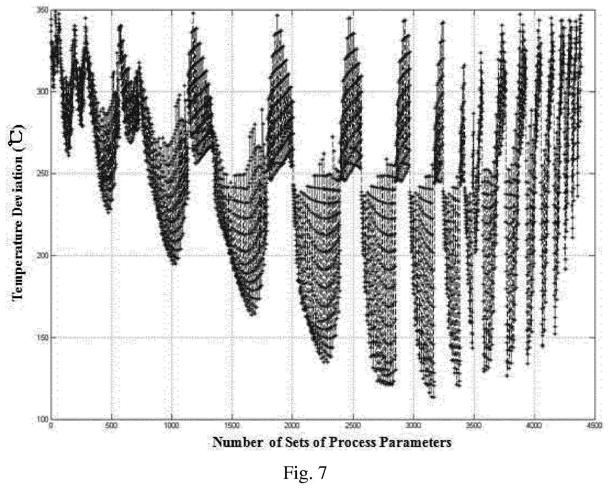

Fig. 7 shows the variation of the temperature deviation ΔT with the number of sets of process parameters (up to 4500) in annealing processes using laser beams with wavelengths of 500 nm and 800 nm. As can be seen from the figure, the temperature deviation ranges from 110 °C to 350 °C, demonstrating that the annealing method disclosed herein provides an effective feasible solution for reducing pattern effects.

The present invention provides another method for annealing with the laser annealing device as defined above, which includes the following steps:

In step S1, the wafer 1 is placed on the wafer table 2 and process parameters for the surface of the wafer 1 are obtained. The process parameters may include surface dimensions of the wafer and reflectance indices of materials thereof. The process parameters may either be selected based on a type of the wafer 1 from an annealing parameter model established in advance from measured surface dimensions of different types of wafers or obtained by measuring in real time the surface dimensions of the wafer.

In step S2, based on the process parameters, at least two of the lasers 31 are selected to produce laser beams. In addition, different annealing angles are enabled by adjusting the laser adjusting system 4, and different annealing power levels are enabled by adjusting the laser light source system 3. Specifically, based on the reflectance indices of the materials of the wafer, at least two of the lasers 31 may be selected to produce laser beams at different wavelengths and power levels of the laser beams may be adjusted. Additionally, based on the surface dimensions of the wafer, angles of incidence of the laser beams may be adjusted through the rotation and translation members 414 of the laser adjustors 41, thereby enabling different annealing angles.

In step S3, a light spot for annealing the surface of the wafer is jointly formed by the laser beams. Specifically, the light spot may have an energy distribution that is compatible with the surface dimensions of the wafer and the reflectance indices of the materials thereof.

To sum up, in the laser annealing device and methods of the present invention, the wafer 1 is jointly annealed by the laser beams from the multiple independent lasers 31, which have different wavelengths and cooperate in a mutually complementary manner, with a selected optimum set of process parameters. As a result, an optimum annealing temperature can be achieved and surface pattern effects can be effectively reduced. Additionally, with feedbacks from the temperature monitoring system 5 and adjustments effected by the central control system 6, the annealing is performed in a more uniform and controllable manner with a reduced thermal budget and less thermal diffusion, which imparts enhanced process adaptability to the annealing device.

Although a few embodiments of the present invention have been described herein, these embodiments are merely illustrative and should not be construed as limiting the scope of the invention. The invention is defined by the appended claims.

**Claims**

1. A laser annealing device for laser annealing of a wafer (1) on a wafer table (2), comprising:

   a laser light source system (3), comprising at least two lasers (31) configured to output laser beams at a tunable power;
   a laser adjusting system (4) in connection with the laser light source system (3), the laser adjusting system (4) comprising at least two laser adjustors (41) in one-to-one correspondence with the lasers (31), the laser adjusting system (4) configured to monitor the powers of the laser beams and a position of a light spot formed by the laser beams on a surface of the wafer (1) and to adjust a shape of the light spot and angles of incidence of the laser beams;
   a temperature monitoring system (5), configured to measure in real time a temperature at a location on the surface of the wafer (1) at which the light spot is formed; and
   a central control system (6), in connection with each of the laser light source system (3), the laser adjusting system (4), the temperature monitoring system (5) and the wafer table (2), the central control system (6) configured to receive data from the laser light source system (3), the laser adjusting system (4), the temperature monitoring system (5) and the wafer table (2) and to control the laser light source system (3), the laser adjusting system (4) and the wafer table (2),
   wherein
   each of the laser adjustors (41) comprises a spot detection system (411), an energy attenuation system (412), a light homogenization system

   (413) and a rotation and translation member (414) which are disposed sequentially along an optical path, the spot detection system (411) being in connection with a corresponding one of the lasers (31) and the central control system (6), the rotation and translation member (414) disposed above the wafer (1).

2. The laser annealing device according to claim 1, wherein:

   a laser light source control system (8) is connected between the central control system (6) and the laser light source system (3), the laser light source control system (8) configured to receive, from the central control system (6), a control command indicative of a control action on the power of the laser beam output from each of the lasers (31) of the laser light source system (3) and to feed a result of the control action back to the central control system (6); and/or
   a laser adjustment control system (9) is connected between the central control system (6) and the laser adjusting system (4), the laser adjustment control system (9) configured to receive, from the central control system (6), a control command indicative of a control action on each of the laser adjustors (41) of the laser adjusting system (4) and to feed a result of the control action back to the central control system (6); and/or
   a wafer table control system (10) is disposed between the central control system (6) and the wafer table (2), the wafer table control system (10) configured to receive, from the central control system (6), a control command indicative of a control action on movement of the wafer table (2) and to feed a result of the control action back to the central control system (6).

3. The laser annealing device according to claim 1, wherein the temperature monitoring system (5) is a pyrometer or a reflectance detector.

4. The laser annealing device according to claim 1, wherein the lasers (31) are connected to the laser adjustors (41) by optical fibers (7).

5. The laser annealing device according to claim 1, wherein the spot detection system (411) comprises a power meter, a CCD detector and an image collector, wherein the light homogenization system (413) is implemented as a micro-lens array or an optical integrator rod, and wherein the rotation and translation member (414) comprises a galvanometer lens and a piezoelectric ceramic actuator.

6. The laser annealing device according to claim 1, wherein a beam expansion and collimation system (415) is disposed between the energy attenuation system (412) and the light homogenization system (413); and/or wherein an F-θ lens (416) is disposed between the rotation and translation member (414) and the wafer (1).

7. The laser annealing device according to claim 1, wherein the laser beams output from the at least two lasers (31) comprise at least two different wavelengths.

8. A method for annealing using the laser annealing device as defined in any one of claims 1 to 7, comprising the steps of:

S1) placing a wafer (1) on a wafer table (2) and adjusting the wafer (1) to be horizontally oriented;

S2) determining, by the laser adjustors (41) of the laser adjusting system (4), a location of the wafer (1) at which a light spot is formed and determining an optimum set of process parameters based on reflectance at the location;

S3) adjusting the laser light source system (3) and the laser adjusting system (4), exposing the location of the wafer (1) at which the light spot is formed based on the optimum set of process parameters, measuring a temperature at the location by the temperature monitoring system (5) and transmitting the temperature measurement to the central control system (6);

S4) determining whether the temperature is within a predefined temperature range by the central control system (6) based on the received temperature measurement, if not, recording an exposure temperature at the location and, when a subsequent location of the wafer (1) having a same reflectance is to be exposed, adjusting parameters of the laser light source system (3) and of the laser adjusting system (4) so that the wafer (1) is exposed at an exposure temperature within the predefined temperature range, and if yes, causing the wafer table (2) to move the wafer (1) so that the light spot is located at a next location to be exposed; and

S5) determining whether the next location is a final location, if not, repeating steps S2) to S4) and otherwise, ending the method.

9. The method according to claim 8, wherein in step S2), determining an optimum set of process parameters comprises the steps of:

S21) selecting wavelengths for the respective lasers (31);

S22) for one of locations of the wafer (1), determining a plurality of sets of parameters each consisting of angles of incidence and powers of laser beams from the respective lasers (31);

S23) for a selected set of parameters, measuring reflectance and absorbance of the laser beams at the one of locations of the wafer (1) and determining an exposure temperature for the selected set of parameters using a temperature model; and

S24) determining whether the exposure temperature is within a predefined temperature range, if not, performing step S23) for a next set of parameters, if yes, determining the selected set of parameters as the optimum set of process parameters and causing the wafer table (2) to move the wafer (1) to a next location and looping back to step S23), and repeating this method until all the locations of the wafer (1) have been so treated.

10. A method for annealing using the laser annealing device as defined in any one of claims 1 to 7, comprising the steps of:

S1) placing a wafer (1) on a wafer table (2) and obtaining process parameters for the wafer (1);

S2) selecting at least two lasers (31) based on the process parameters, producing laser beams by the selected lasers and adjusting annealing angles and powers for the laser beams; and

S3) annealing a surface of the wafer (1) with a light spot jointly formed by the laser beams.

11. The method according to claim 10, wherein in step S1), the process parameters are selected based on a type of the wafer (1) from an annealing parameter model established in advance from measured surface dimensions of different types of wafers; and/or wherein the process parameters are obtained by measuring in real time surface dimensions of the wafer (1).

12. The method according to claim 10 or 11, wherein the process parameters include surface dimensions of the wafer (1) and reflectance indices of materials thereof.

13. The method according to claim 12, wherein in step S2), based on the reflectance indices of the materials, selecting at least two lasers (31) that produce laser beams at different wavelengths and adjusting powers of the laser beams; and/or wherein based on the surface dimensions, different annealing angles are enabled by adjusting angles of incidence of the laser beams using corresponding ones of the laser adjustors (41).

14. The method according to claim 12, wherein in step S3), the light spot has an energy distribution that is compatible with the dimensions of the wafer (1) and the reflectance indices of the materials thereof.

**Patentansprüche**

1. Laser-Glühvorrichtung zum Laserglühen eines Wafers (1) auf einem Wafer-Tisch (2), umfassend:

   ein Laserlichtquellensystem (3), umfassend mindestens zwei Laser (31), die konfiguriert sind, um Laserstrahlen mit einer abstimmbaren Leistung auszugeben;
   ein Laserjustiersystem (4) in Verbindung mit dem Laserlichtquellensystem (3), das Laserjustiersystem (4) umfassend mindestens zwei Laserjustierer (41) in Eins-zu-Eins-Entsprechung mit den Lasern (31), wobei das Laserjustiersystem (4) konfiguriert ist, um die Leistungen der Laserstrahlen und eine Position eines durch die Laserstrahlen auf einer Oberfläche des Wafers (1) gebildeten Lichtflecks zu überwachen und eine Form des Lichtflecks und Einfallswinkel der Laserstrahlen einzustellen;
   ein Temperaturüberwachungssystem (5), das konfiguriert ist, um in Echtzeit eine Temperatur an einer Stelle auf der Oberfläche des Wafers (1) zu messen, an der der Lichtpunkt gebildet wird; und
   ein zentrales Steuersystem (6) in Verbindung mit jedem von dem Laserlichtquellensystem (3), dem Laserjustiersystem (4), dem Temperaturüberwachungssystem (5) und dem Wafer-Tisch (2), wobei das zentrale Steuersystem (6) konfiguriert ist, um Daten von dem Laserlichtquellensystem (3), dem Laserjustiersystem (4), dem Temperaturüberwachungssystem (5) und dem Wafer-Tisch (2) zu empfangen und das Laserlichtquellensystem (3), das Laserjustiersystem (4) und den Wafer-Tisch (2) zu steuern, wobei
   jeder von den Laserjustierern (41) ein Fleckenerfassungssystem (411), ein Energiedämpfungssystem (412), ein Lichthomogenisierungssystem (413) und ein Rotations- und Translationselement (414) umfasst, die nacheinander entlang eines optischen Pfads angeordnet sind, wobei das Fleckenerfassungssystem (411) in Verbindung mit einem entsprechenden der Laser (31) und dem zentralen Steuersystem (6) ist und das Rotations- und Translationselement (414) über dem Wafer (1) angeordnet ist.

2. Laser-Glühvorrichtung nach Anspruch 1, wobei:

   ein Laserlichtquellen-Steuersystem (8) zwischen dem zentralen Steuersystem (6) und dem Laserlichtquellensystem (3) verbunden ist, wobei das Laserlichtquellen-Steuersystem (8) konfiguriert ist, um von dem zentralen Steuersystem (6) einen Steuerbefehl empfängt, der indikativ für eine Steueraktion auf die Leistung des von jedem der Laser (31) des Laserlichtquellensystems (3) ausgegebenen Laserstrahls ist, und um ein Resultat der Steueraktion an das zentrale Steuersystem (6) zurückzumelden; und/oder
   ein Laserjustiersteuersystem (9) zwischen dem zentralen Steuersystem (6) und dem Laserjustiersystem (4) verbunden ist, wobei das Laserjustiersteuersystem (9) konfiguriert ist, um einen Steuerbefehl von dem zentralen Steuersystem (6) zu empfangen, der indikativ für eine Steueraktion auf jeden der Laserjustierer (41) des Laserjustiersystems (4) ist, und um ein Resultat der Steueraktion an das zentrale Steuersystem (6) zurückzumelden; und/oder
   ein Wafer-Tisch-Steuersystem (10) zwischen dem zentralen Steuersystem (6) und dem Wafer-Tisch (2) angeordnet ist, wobei das Wafer-Tisch-Steuersystem (10) konfiguriert ist, um von dem zentralen Steuersystem (6) einen Steuerbefehl zu empfangen, der indikativ für eine Steueraktion auf eine Bewegung des Wafer-Tischs (2) ist, und um ein Resultat der Steueraktion an das zentrale Steuersystem (6) zurückzumelden.

3. Laser-Glühvorrichtung nach Anspruch 1, wobei das Temperaturüberwachungssystem (5) ein Pyrometer oder ein Reflexionsdetektor ist.

4. Laser-Glühvorrichtung nach Anspruch 1, wobei die Laser (31) über Lichtwellenleiter (7) mit den Laserjustierern (41) verbunden sind.

5. Laser-Glühvorrichtung nach Anspruch 1, wobei das Punkterfassungssystem (411) einen Leistungsmesser, einen CCD-Detektor und einen Bildkollektor umfasst, wobei das Lichthomogenisierungssystem (413) als Mikrolinsenarray oder optischer Integratorstab implementiert ist und wobei das Rotations- und Translationselement (414) eine Galvanometerlinse und einen piezoelektrischen Keramikaktuator umfasst.

6. Laser-Glühvorrichtung nach Anspruch 1, wobei zwischen dem Energiedämpfungssystem (412) und dem Lichthomogenisierungssystem (413) ein Strahlexpansions- und Kollimationssystem (415) angeordnet ist; und/oder wobei eine F-0-Linse (416) zwischen dem Rotations- und Translationselement (414) und dem Wafer (1) angeordnet ist.

7. Laser-Glühvorrichtung nach Anspruch 1, wobei die von den mindestens zwei Lasern (31) ausgegebenen Laserstrahlen mindestens zwei unterschiedliche Wellenlängen umfassen.

**8.** Verfahren zum Glühen unter Verwendung der Laser-Glühvorrichtung nach einem der Ansprüche 1 bis 7, umfassend die folgenden Schritte:

S1) Auflegen eines Wafers (1) auf einen Wafer-Tisch (2) und Einstellen des Wafers (1), um horizontal ausgerichtet zu sein;

S2) Bestimmen, durch die Laserjustierer (41) des Laserjustiersystems (4), einer Stelle des Wafers (1), an der ein Lichtfleck gebildet wird, und Bestimmen eines optimalen Satzes von Prozessparametern basierend auf dem Reflexionsgrad an der Stelle;

S3) Einstellen des Laserlichtquellensystems (3) und des Laserjustiersystems (4), Belichten der Stelle des Wafers (1), an der der Lichtfleck gebildet wird, basierend auf dem optimalen Satz von Prozessparametern, Messen einer Temperatur an der Stelle durch das Temperaturüberwachungssystem (5) und Übermitteln der Temperaturmessung an das zentrale Steuersystem (6);

S4) Bestimmen, durch das zentrale Steuersystem (6), ob die Temperatur innerhalb eines vordefinierten Temperaturbereichs ist, basierend auf der empfangenen Temperaturmessung, wenn nicht, Aufzeichnen einer Belichtungstemperatur an der Stelle und, wenn eine nachfolgende Stelle des Wafers (1), die einen gleichen Reflexionsgrad aufweist, belichtet werden soll, Einstellen von Parametern des Laserlichtquellensystems (3) und des Laserjustiersystems (4), sodass der Wafer (1) mit einer Belichtungstemperatur innerhalb des vordefinierten Temperaturbereichs belichtet wird, und, wenn ja, Veranlassen, dass der Wafer-Tisch (2) den Wafer (1) bewegt, sodass sich der Lichtpunkt an einer nächsten zu belichtenden Stelle befindet; und

S5) Bestimmen, ob die nächste Stelle eine letzte Stelle ist, wenn nicht, Wiederholen der Schritte S2) bis S4) und andernfalls Beenden des Verfahrens.

**9.** Verfahren nach Anspruch 8, wobei in Schritt S2) ein Bestimmen eines optimalen Satzes von Prozessparametern die folgenden Schritte umfasst:

S21) Auswählen von Wellenlängen für die jeweiligen Laser (31);

S22) für eine der Stellen des Wafers (1), Bestimmen einer Vielzahl von Sätzen von Parametern, die jeweils aus Einfallswinkeln und Leistungen von Laserstrahlen der jeweiligen Laser (31) bestehen;

S23) für einen ausgewählten Satz von Parametern, Messen von Reflexion und Absorption der Laserstrahlen an der einen Stelle des Wafers (1) und Bestimmen einer Belichtungstemperatur für den ausgewählten Satz von Parametern unter Verwendung eines Temperaturmodells; und

S24) Bestimmen, ob die Belichtungstemperatur innerhalb eines vordefinierten Temperaturbereichs ist, wenn nicht, Ausführen von Schritt S23) für einen nächsten Satz von Parametern, wenn ja, Bestimmen des ausgewählten Satzes von Parametern als den optimalen Satz von Prozessparametern und Veranlassen, dass der Wafer-Tisch (2), den Wafer (1) zu einer nächsten Stelle bewegt, und Zurückkehren zu Schritt S23) und Wiederholen dieses Verfahrens, bis alle Stellen des Wafers (1) so behandelt worden sind.

**10.** Verfahren zum Glühen unter Verwendung der Laser-Glühvorrichtung nach einem der Ansprüche 1 bis 7, umfassend die folgenden Schritte:

S1) Auflegen eines Wafers (1) auf einen Wafer-Tisch (2) und Erlangen von Prozessparametern für den Wafer (1);

S2) Auswählen von mindestens zwei Lasern S1) basierend auf den Prozessparametern, Erzeugen von Laserstrahlen durch die ausgewählten Laser und Einstellen von Glühwinkeln und Leistungen für die Laserstrahlen; und

S3) Glühen einer Oberfläche des Wafers (1) mit einem von den Laserstrahlen gemeinsam gebildeten Lichtfleck.

**11.** Verfahren nach Anspruch 10, wobei in Schritt S1) die Prozessparameter basierend auf einem Typ des Wafers (1) aus einem Glühparametermodell ausgewählt werden, das im Voraus aus gemessenen Oberflächenabmessungen verschiedener Typen von Wafern erstellt wurde; und/oder wobei die Prozessparameter durch Messen der Oberflächenabmessungen des Wafers (1) in Echtzeit erlangt werden.

**12.** Verfahren nach Anspruch 10 oder 11, wobei die Prozessparameter die Oberflächenabmessungen des Wafers (1) und die Reflexionsindizes von Materialien davon umfassen.

**13.** Verfahren nach Anspruch 12, wobei in Schritt S2) basierend auf den Reflexionsindizes der Materialien, Auswählen von mindestens zwei Lasern (31), die Laserstrahlen mit unterschiedlichen Wellenlängen erzeugen, und Einstellen von Leistungen der Laserstrahlen; und/oder wobei den Oberflächenabmessungen unterschiedliche Glühwinkel ermöglicht werden, indem die Einfallswinkel der Laserstrahlen unter Verwendung entsprechender Lasereinstellvorrichtungen (41) eingestellt werden.

**14.** Verfahren nach Anspruch 12, wobei in Schritt S3) der Lichtfleck eine Energieverteilung aufweist, die mit den Abmessungen des Wafers (1) und den Reflexionsindizes der Materialien davon kompatibel ist.

**Revendications**

**1.** Dispositif de recuit au laser pour le recuit au laser d'une plaquette (1) sur une table de plaquette (2), comprenant :

un système de source de lumière laser (3), comprenant au moins deux lasers (31) conçus pour émettre des faisceaux laser à une puissance ajustable ;

un système de réglage de laser (4) en liaison avec le système de source de lumière laser (3), le système de réglage de laser (4) comprenant au moins deux dispositifs de réglage de laser (41) en correspondance biunivoque avec les lasers (31), le système de réglage de laser (4) étant conçu pour surveiller les puissances des faisceaux laser et une position d'un point lumineux formé par les faisceaux laser sur une surface de la plaquette (1) et pour régler une forme du point lumineux et des angles d'incidence des faisceaux laser ;

un système de surveillance de la température (5), conçu pour mesurer en temps réel une température à un emplacement sur la surface de la plaquette (1) où le point lumineux se forme ; et

un système de commande central (6), en liaison avec chacun des systèmes de sources de lumière laser (3), le système de réglage de laser (4), le système de surveillance de la température (5) et la table de plaquette (2), le système de commande central (6) étant conçu pour recevoir des données provenant du système de source de lumière laser (3), du système de réglage de laser (4), du système de surveillance de la température (5) et de la table de plaquette (2) et pour commander le système de source de lumière laser (3), le système de réglage de laser (4) et la table de plaquette (2),

dans lequel

chacun des dispositifs de réglage de laser (41) comprend un système de détection de point lumineux (411), un système d'atténuation d'énergie (412), un système d'homogénéisation de la lumière (413) et un élément de rotation et de translation (414) qui sont disposés séquentiellement le long d'un chemin optique, le système de détection de point lumineux (411) étant en liaison avec un laser correspondant parmi les lasers (31) et le système de commande central (6), l'élément de rotation et de translation (414) étant disposé au-dessus de la plaquette (1).

**2.** Dispositif de recuit au laser selon la revendication 1, dans lequel :

un système de commande de source de lumière laser (8) est relié entre le système de commande central (6) et le système de source de lumière laser (3), le système de commande de source de lumière laser (8) étant conçu pour recevoir, à partir du système de commande central (6), une instruction de commande indiquant une action de commande sur la puissance du faisceau laser émis par chacun des lasers (31) du système de source de lumière laser (3) et pour renvoyer un résultat de l'action de commande au système de commande central (6) ; et/ou

un système de commande de réglage de laser (9) est relié entre le système de commande central (6) et le système de réglage de laser (4), le système de commande de réglage de laser (9) étant conçu pour recevoir, à partir du système de commande central (6), une instruction de commande indiquant une action de commande sur chacun des dispositifs de réglage de laser (41) du système de réglage de laser (4) et pour renvoyer un résultat de l'action de commande au système de commande central (6) ; et/ou

un système de commande de table de plaquette (10) est disposé entre le système de commande central (6) et la table de plaquette (2), le système de commande de table de plaquette (10) étant conçu pour recevoir, à partir du système de commande central (6), une instruction de commande indiquant une action de commande sur le mouvement de la table de plaquette (2) et pour renvoyer un résultat de l'action de commande au système de commande central (6).

**3.** Dispositif de recuit au laser selon la revendication 1, dans lequel le système de surveillance de la température (5) est un pyromètre ou un détecteur de réflectance.

**4.** Dispositif de recuit au laser selon la revendication 1, dans lequel les lasers (31) sont reliés aux dispositifs de réglage de laser (41) par des fibres optiques (7).

**5.** Dispositif de recuit au laser selon la revendication 1, dans lequel le système de détection de point lumineux (411) comprend un wattmètre, un détecteur CCD et un dispositif de collecte d'images, dans lequel le système d'homogénéisation de la lumière (413) est mis en œuvre sous la forme d'un réseau de microlentilles ou d'une barre d'intégration optique, et dans lequel l'élément de rotation et de translation (414) comprend une lentille galvanométrique et un actionneur céramique piézoélectrique.

**6.** Dispositif de recuit au laser selon la revendication 1, dans lequel un système de dilatation et de collimation du faisceau (415) est disposé entre le système d'atténuation d'énergie (412) et le système d'homogénéisation de la lumière (413) ; et/ou dans lequel une lentille F-θ (416) est disposée entre l'élément de rotation et de translation (414) et la plaquette (1).

7. Dispositif de recuit au laser selon la revendication 1, dans lequel les faisceaux laser émis par les au moins deux lasers (31) comprennent au moins deux longueurs d'onde différentes.

8. Procédé de recuit au moyen du dispositif de recuit au laser selon l'une quelconque des revendications 1 à 7, comprenant les étapes suivantes :

S1) placer une plaquette (1) sur une table de plaquette (2) et régler la plaquette (1) pour qu'elle soit orientée horizontalement ;

S2) déterminer, au moyen des dispositifs de réglage de laser (41) du système de réglage de laser (4), un emplacement de la plaquette (1) où un point lumineux se forme et déterminer un ensemble optimal de paramètres de traitement sur la base de la réflectance à cet emplacement ;

S3) régler le système de source de lumière laser (3) et le système de réglage de laser (4), exposer l'emplacement de la plaquette (1) où le point lumineux se forme sur la base de l'ensemble optimal de paramètres de traitement, mesurer une température à l'emplacement au moyen du système de surveillance de la température (5) et transmettre la mesure de la température au système de commande central (6) ;

S4) déterminer si la température est comprise ou non dans une plage de températures prédéfinie par le système de commande central (6) sur la base de la mesure de la température reçue, dans le cas contraire, enregistrer une température d'exposition à l'emplacement et, lorsqu'un emplacement suivant de la plaquette (1) ayant une même réflectance doit être exposé, régler les paramètres du système de source de lumière laser (3) et du système de réglage de laser (4) de sorte que la plaquette (1) est exposée à une température d'exposition comprise dans la plage de températures prédéfinie et, si tel est le cas, amener la table de plaquette (2) à déplacer la plaquette (1) de sorte que le point lumineux se situe à un emplacement suivant à exposer ; et

S5) déterminer si l'emplacement suivant est ou non un emplacement final, si tel n'est pas le cas, répéter les étapes S2) à S4) et sinon, arrêter le procédé.

9. Procédé selon la revendication 8, dans lequel à l'étape S2), la détermination d'un ensemble optimal de paramètres de traitement comprend les étapes suivantes :

S21) sélectionner des longueurs d'onde pour les lasers respectifs (31) ;

S22) pour l'un des emplacements de la plaquette (1), déterminer une pluralité d'ensembles de paramètres consistant chacun en des angles d'incidence et des puissances de faisceaux laser provenant des lasers respectifs (31) ;

S23) pour un ensemble sélectionné de paramètres, mesurer la réflectance et de l'absorbance des faisceaux laser à l'un des emplacements de la plaquette (1) et déterminer une température d'exposition pour l'ensemble sélectionné de paramètres à l'aide d'un modèle de température ; et

S24) déterminer si la température d'exposition est comprise ou non dans une plage de températures prédéfinie, dans le cas contraire, exécuter l'étape S23) pour un ensemble suivant de paramètres, si tel est le cas, déterminer l'ensemble sélectionné de paramètres comme ensemble optimal de paramètres de traitement et amener la table de plaquette (2) à déplacer la plaquette (1) jusqu'à un emplacement suivant et revenir à l'étape S23), et répéter ce procédé jusqu'à ce que tous les emplacements de la plaquette (1) aient été traités ainsi.

10. Procédé de recuit au moyen du dispositif de recuit au laser selon l'une quelconque des revendications 1 à 7, comprenant les étapes suivantes :

S1) placer une plaquette (1) sur une table de plaquette (2) et obtenir des paramètres de traitement pour la plaquette (1) ;

S2) sélectionner au moins deux lasers (31) sur la base des paramètres de traitement, produire des faisceaux laser par les lasers sélectionnés et régler les angles et les puissances de recuit pour les faisceaux laser ; et

S3) recuire une surface de la plaquette (1) avec un point lumineux formé conjointement par les faisceaux laser.

11. Procédé selon la revendication 10, dans lequel à l'étape S1), les paramètres de traitement sont sélectionnés sur la base d'un type de plaquette (1) à partir d'un modèle de paramètres de recuit établi à l'avance à partir de dimensions de surface mesurées de différents types de plaquettes ; et/ou dans lequel les paramètres de traitement sont obtenus en mesurant en temps réel les dimensions de surface de la plaquette (1).

12. Procédé selon la revendication 10 ou 11, dans lequel les paramètres de traitement comprennent les dimensions de surface de la plaquette (1) et les indices de réflectance des matériaux de celle-ci.

13. Procédé selon la revendication 12, dans lequel, à l'étape S2), sur la base des indices de réflectance des matériaux, on sélectionne au moins deux lasers (31) qui produisent des faisceaux laser à des longueurs d'onde différentes et on règle les puissances des faisceaux laser ; et/ou dans lequel, sur la base des dimensions de surface, on valide différents angles de recuit en réglant les angles d'incidence des faisceaux laser au moyen de dispositifs de réglage de laser correspondants parmi les dispositifs de réglage de laser (41).

14. Procédé selon la revendication 12, dans lequel à l'étape S3), le point lumineux a une distribution d'énergie qui est compatible avec les dimensions de la plaquette (1) et les indices de réflectance des matériaux de celle-ci.

Fig. 1

Fig. 2

Fig. 3a

Fig. 3b

Fig. 4

414

413    415    412    411

416

1

Fig. 5

Fig. 6

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013196455 A1

- US 2014097171 A1